# EUROPEAN PATENT SPECIFICATION

(11) **EP 1 280 192 B1**
(45) Date of publication and mention of the grant of the patent: **06.10.2004**
(21) Application number: 01948177.9
(22) Date of filing: 02.07.2001
(51) Int. Cl.: H01L 21/265, B82B 3/00, H01J 37/30

(54) **DEVICE FOR FORMING NANOSTRUCTURES ON THE SURFACE OF A SEMICONDUCTOR WAFER BY MEANS OF ION BEAMS**
APPARAT ZUR FORMUNG VON NANOSTRUKTUREN AUF DER OBERFLÄCHE VON HALBLEITERSCHEIBEN MITTELS IONENSTRAHL
INSTALLATION POUR FORMER DES NANOSTRUCTURES A LA SURFACE DE PLAQUETTES DE SEMI-CONDUCTEUR PAR FAISCEAUX D'IONS

(30) Priority: 04.07.2000 RU 2000117335
(43) Date of publication of application: 29.01.2003
(73) Proprietor: Sceptre Electronics Limited, Road Town, Tortola (VG)
(72) Inventor: SMIRNOV, Valery Konstantinovich, Yaroslavl, 150003 (RU); KIBALOV, Dmitry Stanislavovich, Yaroslavl, 150051 (RU)
(74) Representative: Engel, Christoph Klaus
(86) International application number: PCT/RU2001/000261
(87) International publication number: WO 2002/003419

(56) References cited:
- EP-A- 0 735 564
- EP-A2- 0 275 965
- WO-A-99/41765
- WO-A1-98/29901
- FR-A1- 2 407 567
- RU-C1- 2 007 783
- US-A- 4 874 947
- US-A- 5 483 077

## Description

### Technology

This invention refers to the sphere of electronic and vacuum technology, in particular to the units for the formation of various structures and coatings on semiconductor wafers. It can be used to develop new-generation semiconductor devices, as well as in optical instrument-making.

### Previous Technological Level

There exists a unit for processing of semiconductor wafers, which incorporates a vacuum unit, vacuum exhaust devices, and a wafer-processing device (Patent 0275965, cl. HO1 J 37/32 1988). In this unit, with a single-wave transmission mode at a frequency of 2.45 GHz, the plasma beam cross-section and the diameter of the processed wafers are located in the range of 76-100 mm, while the plasma flow angle relative to the normal to the processed wafer surface is defined with an approximation.

This solution is regarded as the closest analog (prototype) Further units are disclosed in WO9941765 and EP 735564.

### Contents of Invention

The essence of this invention as claimed in claim 1 lies in the development of a unit for production of nanostructures suitable for making semiconductors with a high integration level, and high-resolution optical devices, and is aimed at enlarging the functionality of the existing unit.

The unit for the formation of nanostructures on semiconductor wafer surface incorporates a vacuum chamber equipped with exhaust and annealing systems, a semiconductor wafer input device, a source of ions with controlled power, a mass separator, an electron gun, a wafer holder, and an ion current meter. The unit is equipped with an ion beam transport column, a quadrupole mass analyzer, an optical microscope, and a computer. The axes of the ion beam transport column, the optical microscope and the electron gun are situated on the same plane with the normal to the semiconductor wafer in the working position, and intersect in one point located on the front surface of the wafer; the angle between their axes is the minimum one; the computer scans the ion beam through a set of sites by moving the wafer along the given site coordinates, and displays images of the wafer surface in secondary electrons, and provides for combining ion and electron beam solutions on the surface of the wafer.

The vacuum chamber achieves a vacuum of 5•10⁻¹⁰ torrs (1Torr ≡ 133.3Pa). The ion beam diameter can vary from 0.9 µm to 1.5 µm, with an ion energy value of 5 keV.

### Short Description of Design Figures

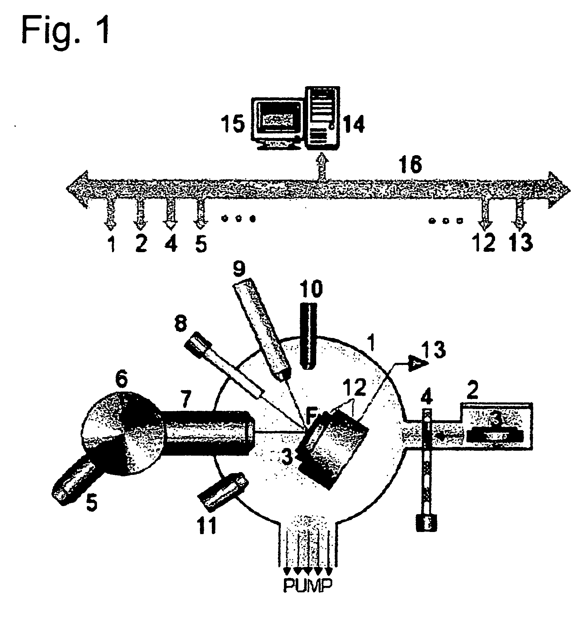

The invention is illustrated with graphic materials. The drawing representing the unit for nanostructure formation by ion beams on the semiconductor wafer surface contains ultra-high-vacuum chamber 1 capable of creating vacuum of 5 10⁻¹⁰ torr, with the necessary exhaust and annealing systems (not shown on the drawing); semiconductor wafer input (into chamber 1) device 2 with a diameter of 200 mm; semiconductor wafer 3; gateway valve 4; source of ions with controlled power 5; mass separator 6; ion beam transport column 7; optical microscope 8; electron gun 9; quadrupole mass analyzer 10; electron detector 11; wafer holder 12; ion current meter 13, computer 14, monitor 15, interface 16.

### Best Implementation Option

The technical result to be obtained from implementing the invention is production of thin-film semiconductor structures suitable for creating new-generation semiconductor devices and diffracting screens.

This result can be achieved as follows. Wafer 3 is placed in the vacuum chamber 1 with a residual pressure of 5-10⁻¹⁰ torr. A column source of the duoplasmatron type is filled with nitrogen to generate a nitrogen ion flow. The ion flow energy and wafer radiation angle values are set. An area of S = 200 x 200 sq. µm on the wafer surface is evenly irradiated with a nitrogen ion flow under a current of I = 250 nA. The following conditions are to be met. The axis of the ion beam transport column 7, the optical microscope 8, and the electron gun 9 must intersect in one point F located on the front side of the wafer 3 surface. This point must be the focal point of the ion beam transport column 7, the optical microscope 8, and the electron gun 9. The ion beam transport column 7, the optical microscope 8, and the electron gun 9 must be located on the front side of the wafer, and the angle between them must have the minimum value. The ion source 5 is a duoplasmatron-type source operating on such gases as argon, oxygen and nitrogen, and providing ion energy values in the range of 500 eV to 20 keV.

The mass separator 6 is a mass separator with a mass range from 1 to 100 a.e.m., and has a relative mass resolution of 5 a.e.m. The ion beam transport column 7 provides for changing the raster size and the raster side ratio. The ion beam diameter must be about 1 µm (from 0.9 µm to 1.5 µm) with an ion energy value of 5 keV. The and Y directions of the ion beam scanning must coincide with the movement directions of the wafer holder 12. The electron control of the ion beam shift along the Y axis must not be less than the double raster size in the Y direction. The ion beam sweep linearity in the Y direction must be controlled.

The optical microscope 8 is made with wafer highlight, an 8-100-time magnification, and image display on the TV monitor. The electron gun 9 creates an electron energy value of 100 eV to 10 keV, an electron beam current of 5 µA, and spot size of about 100 nm. The and Y ion beam scanning directions must coincide with the movement directions of the wafer holder 12.

The electron control of the ion beam shift along the Y axis must not be less than the double raster size in the Y direction.

The ion beam sweep linearity in the Y direction must be controlled.

The quadrupole mass analyzer 10 is equipped with the optics for gathering both positive and negative secondary ions.

The range of measured masses is from 1 to 100 a.e.m. The absolute mass resolution is 5 a.e.m. The electron detector 11 is a detector of secondary electrons.

The wafer holder 12 provides for wafer inclination in such a way that the normal to the wafer remains on the plane of the axes of the ion beam transport column 7, the optical microscope 8, and the electron gun 9. The inclination angle of the wafer normal to the ion beam transport column 7 axis must be from 0 to 90°. The wafer rotation must be from 0° to 360°. There is no need for continuous rotation. The angle precision must be ±0,5°. The wafer holder should provide for heating the wafer from the room temperature to 700°. The X and Y wafer movement directions should lie on the wafer plane. The wafer movement in the Z direction should provide for superposing the wafer surface plane with the focal point of the ion beam transport column 7, the optical microscope 8, and the electron gun 9. The wafer movement error should be about 1 µm. The ion current meter 13 provides for measuring the current from the wafer.

The computer 14 with monitor 15 and interface 16 are designed for controlling the whole unit. The computer 14 scans the ion beam through a set of sites by moving the wafer along the given site coordinates, while the stopping of the ion beam should be defined by the wafer current integral, as well as by the signal of certain ions detected by the quadrupole mass analyzer 10.

The computer provides for receiving wafer surface images both in secondary electrons generated by the scanning electron or ion beams, and through the optical microscope 8, to superpose the ion and electron beam rasters on the wafer surface.

### Industrial Application

This invention refers to the sphere of electronic and vacuum technology, in particular to the units for the formation of various structures and coatings on semiconductor wafers. It can be used to develop new-generation semiconductor devices, as well as in optical instrument-making. The invention can be used to create units for production of nanostructures suitable for making semiconductors with a high integration level, and high-resolution optical devices.

## Claims

1. A unit for the formation of nanostructures on semiconductor wafer surface incorporating a vacuum chamber (1) equipped with exhaust and annealing systems, a semiconductor wafer (3) input device (2), a source of ions with controlled power (5), a mass separator (6), an electron gun (9), an electron detector (11), a wafer holder (12), and an ion current meter (13), whereby the unit is equipped with an ion beam transport column (7), a quadrupole mass analyzer(10), an optical microscope (8), and a computer (15); whereby the axes of the ion beam transport column, the optical microscope and the electron gun being situated on the same plane normal to the semiconductor wafer in the working position, and intersecting in one point located on the front surface of the wafer; whereby the ion beam transport column, the optical microscope and the electron gun being situated on the front side of the wafer, and the angle between their axes is minimized; and whereby the computer scans the ion beam through a set of sites by moving the wafer along the given site coordinates, and displays images of the wafer surface in secondary electrons, and provides for combining ion and electron beams on the surface of the wafer.

2. The unit of claim 1, **characterised in that** its vacuum chamber achieves a vacuum of 5•10⁻¹⁰ torr (1 Torr ≡ 133.3Pa).

3. The unit of claim 1, **characterised in that** the ion beam diameter can vary from 0.9 µm to 1.5 µm, with an ion energy value of 5 keV.

## Patentansprüche

1. Einrichtung zur Erzeugung von Nanostrukturen auf der Oberfläche von Halbleiterscheiben, umfassend eine mit Absaug- und Glüheinrichtungen ausgestattete Vakuumkammer (1), ein Gerät (2) zum Einlegen von Halbleiterscheiben (3), eine Ionenquelle mit geregelter Leistung (5), einen Massenseparator (6), eine Elektronenkanone (9), einen Elektronendetektor (11), einen Scheibenträger (12) und ein Ionenstrommessgerät (13), wobei die Einrichtung mit einer Ionenstrahl-Transfersäule (7), einem Quadrupolmassenanalysator (10), einem optischen Mikroskop (8) und einem Computer (14) ausgestattet ist; wobei die Achsen der Ionenstrahl-Transfersäule, des optischen Mikroskops und der Elektronenkanone in Arbeitsstellung auf derselben Ebene lotrecht zu der Halbleiterscheibe liegen und sich in einem auf der Vorderfläche der Halbleiterscheibe befindlichen Punkt schneiden; wobei sich die Ionenstrahl-Transfersäule, das optische Mikroskop und die Elektronenkanone an der Vorderseite der Halbleiterscheibe befinden und der von ihren Achsen eingeschlossene Winkel minimiert ist; und wobei der Computer den Ionenstrahl über einen Positionssatz abtastet, indem die Halbleiterscheibe entlang der vorgegebenen Positionskoordinaten bewegt wird, und Bilder der Halbleiterscheibenoberfläche in Sekundärelektronen darstellt, und zusammengefasste Ionen- und Elektronenstrahlen auf der Halbleiterscheibenoberfläche bereitstellt.

2. Einrichtung nach Anspruch 1, **dadurch gekennzeichnet, dass** die Vakuumkammer ein Vakuum von 5•10⁻¹⁰ Torr erreicht (1 Torr ≡ 133,3 Pa).

3. Einrichtung nach Anspruch 1, **dadurch gekennzeichnet, dass** der Ionenstrahldurchmesser in einem Bereich von 0,9 µm bis 1,5 µm verändert werden kann, mit einem Ionenenergiewert von 5 keV.

## Revendications

1. Unité pour la formation de nanostructures sur des surfaces de galettes semi-conductrices incorporant une chambre sous vide (1) équipée de systèmes d'aspiration et de recuit, un dispositif (2) d'entrée de galettes semi-conductrices (3), une source d'ions avec une alimentation électrique commandée (5), un séparateur de masse (6), un pistolet à électrons (9), un détecteur d'électrons (11), un support de galette (12) et un ampèremètre à ions (13), l'unité étant équipée d'une colonne de transport de rayon ionique (7), un analyseur de masse quadripolaire (18), un microscope optique (8) et un ordinateur (15), les axes de la colonne de transport de rayon ionique, le microscope optique et le canon à électrons étant situés sur le même plan normal par rapport à la galette semi-conductrice dans la position de travail et se croisant en un point situé sur la face avant de la galette, la colonne de transport de rayon ionique, le microscope optique et le canon à électrons étant situés sur la face avant de la galette, et l'angle entre leurs axes étant minimisés, et l'ordinateur balayant le rayon ionique à travers une série de sites en déplaçant la galette le long des coordonnées du site données en déplaçant la galette le long des coordonnées de site et affichant des images de la surface de galette dans des électrons secondaires et l'ordinateur étant prévu pour associer les rayons ioniques et électroniques sur la surface de la galette.

2. Unité de la revendication 1, **caractérisée en ce que** sa chambre sous vide atteint un vide de 5•10⁻¹⁰ Torr (1 Torr ≡ 133.3 Pa).

3. Unité de la revendication 1 **caractérisée en ce que** le diamètre de rayon ionique peut varier de 0,9 µm à 1,5 µm avec une valeur énergétique ionique de 5 keV.
